Europäisches Patentamt

European Patent Office

Office européen des brevets

(19)

(11) **EP 0 465 034 B1**

(12)

# EUROPEAN PATENT SPECIFICATION

(45) Date of publication and mention
of the grant of the patent:
**14.08.1996 Bulletin 1996/33**

(51) Int Cl.6: **G03F 7/033**, G03F 7/115

(21) Application number: **91305384.9**

(22) Date of filing: **12.06.1991**

(54) **Photosensitive resin composition for flexographic printing**

Lichtempfindliche Flexodruckzusammensetzung

Composition de résine photosensible pour l'impression flexographique

(84) Designated Contracting States:
**BE DE FR GB IT**

(30) Priority: **18.06.1990 JP 158960/90**

(43) Date of publication of application:
**08.01.1992 Bulletin 1992/02**

(73) Proprietor: **NIPPON PAINT CO., LTD.**
**Osaka-shi Osaka 530 (JP)**

(72) Inventors:
• **Ueda, Koichi**
**Neyagawa-shi, Osaka-fu (JP)**
• **Konishi, Katusji**
**Ibaraki-shi, Osaka-fu (JP)**
• **Kanda, Kazunori**
**Yao-shi, Osaka-fu (JP)**

(74) Representative: **Perry, Robert Edward et al**
**GILL JENNINGS & EVERY**
**Broadgate House**
**7 Eldon Street**
**London EC2M 7LH (GB)**

(56) References cited:
EP-A- 0 068 599          EP-A- 0 335 399
EP-A- 0 403 096          GB-A- 2 024 441

**Description**

FIELD OF THE INVENTION

The present invention relates to an improvement of a photosensitive resin composition which is used for flexographic printing.

BACKGROUND OF THE INVENTION

Flexographic printing is a method employing flexible reliefs made from rubber or a laminate of rubber and plastic and therefore has so good ink tranferability that it might be possible to print on a rough surface, such as on corrugated cardboards. However, since the reliefs are easily deformed by printing pressure, the thickening of printed images, so-called "dot gain", is liable to occur and thus it is difficult to obtain sharp and good printed images. Accordingly, it is considered that the flexographic printing is inferior to letter press printing or offset printing.

In order to reduce the dot gain, Japanese Kokai Publications 6392/1980 and 47966/1968 propose resin plates for flexographic printing, which provide dots which are difficult to be deformed by printing pressure. Japanese Kokai Publication 970/1990 also proposes a photosensitive resin plate for flexographic printing, which provides smaller relief than a negative image, thus making relief image smaller than negative film images by the loss occruing when printed. The resin plates of the former patents have a structure comprising two layers which are different in hardness from each other, of which the upper layer to be contacted with paper has a higher hardness than that of the lower layer and the lower layer is softer as absorbing the printing pressure. In this method, however, a platemaking process is complicated because of the two layer construction of the photosensitive layer. In the latter patent's method, an air layer is provided between the negative film and the resin plate and an exposure is then conducted, whereby the oxygen in the air layer inhibits the polymerization reaction in some degree to result in obtaining a relief smaller than the negative image. The method, however, has drawbacks in that it is difficult to handle because the photosensitive resin is liquid and that resulting dots are flagile.

SUMMARY OF THE INVENTION

The present invention provides a photosensitive resin plate which effectively prevents dot gain by covering the photosensitive resin layer with a specific matte layer. The photosensitive resin plate of the present invention comprises a substrate, a photosensitive resin layer formed on the substrate and a resin matte layer formed on the photosensitive resin layer, wherein the resin matte layer contains a polymerization inhibiting material.

DETAILED DESCRIPTION OF THE INVENTION

The resin matte layer is usually provided for preventing a negative film from sticking onto the resin plate and mainly made of various kinds of resins, such as cellulose, polyvinyl alcohol, polyamide and polyacrylamide . In addition to the main resin, the matte layer generally contains dyes (e.g. eosin, methylene blue, rose bengal and erythrosine), inorganic particles (e.g. silica), organic microparticles (e.g. microgels obtained by internally crosslinking styrene or acryl monomers), surfactants and distilled water.

The matte layer generally has a thickness of 0.5 to 100 micron, preferably 1.0 to 10 micron. If the thickness is less than 0.5 micron, the effect of the matte layer is poor, thus resulting in the decline of the preventive effects of stickiness to the negative film and the decline of the photopolymerization inhibiting effects. If the thickness is more than 100 micron, the workability of the platemaking process is poor and the quality of the printed image is also poor.

According to the present invention, the resin matte layer further contains a polymerization inhibiting material (e.g. polymerization inhibitors, polymerization stoppers, chain transferring agents, polymerization regulators, antioxidants and ultraviolet absorbers). The polymerization inhibiting material can be compatible or incompatible with the resin matte composition, but preferred is a material compatible with it. The material can also be compatible, partial compatible or incompatible with the photosensitive resin layer, and preferred is a material partically compatible with it. In other words, it is desired that most of the polymerization inhibiting materials are present in around the interface between the photosensitive resin layer and the matte layer. By the term "compatible" herein is meant that the polymerization inhibiting material is substantially completely dissolved in the host resins and by the term "incompatible" herein is meant that the photopolymerization inhibiting material is substantially indissoluble in the host resins. The term "partial compatible" in the context means either that the polymerization inhibiting material is impregnated in the photosensitive resin layer in a low concentration at the interface between the photosensitive resin layer and the matte layer, or that the polymerization inhibiting material is not dissolved but dispersed in them in the condition of domain constructions or separated layer constructions. It is preferred that the polymerization inhibiting material is one which does not transfer into the photosensitive resin layer with time and accumulates at the interface, thus selecting from the compounds which is partial compatible. The compatibility is varied depending not only upon molecular constructions, molecular weight, functional groups on the molecules and solubility parameters, but also upon temperature, layer thickness and mixing ratio when mixed. Typical examples of the radical polymerization inhibitors are hydroquinone, alkyl or aryl-substituted hydroquinones, 2,6-di-t-butyl-4-methylphenol, p-methoxyphenol, p-butylpyrocatechol, pyrogallol, β-naphthol, 2,6-di-t-butyl-p-cresol, phenothiazine, pyridine, nitrobenzene, dinitrobenzene, nitrosonaphthol, and cupferrone . Typical examples of the polymerization regulators and polymerization stoppers are dimethylxanthiogen disulfide, sodium dimethyldithiocarbamate, sodium diethyldithiocarbamate and sodium dibutyldithiocarbamate. Typical examples of the chain transferring agents are thiol compounds (e.g. laurylmercaptane, dodecylmercaptane). Typical examples of the antioxidants are phenol antioxidants (e.g. phenol, cresol, β-naphthol, t-butylphenol); phosphate antioxidants (e.g. triphenylphosphine, triphenylphosphite, trilauryltrithiophosphite, hexamethylphospholylamide, diphenyldecylphosphite, dicresylphosphite); sulfur antioxidants (e.g. 2-mercaptobenzimidazole, dilauryl thiodipropionate, tetramethylthiuram monosulfide, zinc dibutyldithiocarbamate); amine antioxidants (e.g. aldol-a-naphthylamine, N,N'-diphenyl-p-phenylenediamine, 1-(2-hydroxyethyl)-2,2,4-trimethyldecahydroquinone, bis(2,2,6,6-tetramethyl-4-pyperidinyl) sebacate); the other antioxidants (e.g. [2,2'-thiobis(4-t-octylphenolate)]-n-butylamine nickel, cobalt dicyclohexyldithiophosphinate ). Typical examples of the ultraviolet absorbers are benzophenones (e.g. 2-hydroxy-4-methoxybenzophenone, 2,4-dihydroxybenzophenone, 2,2'-hydroxy-4,4'-dimethoxybenzophenone, 2,4-dibenzoylresolcine); benzotriazoles (e.g. 2-(2'-hydroxy-5'-methylphenyl)benzotriazole, 2-(2'-hydroxy-3'-t-butyl-5'-methylphenyl)benzotriazole); phenyl benzoates (e.g. resolcine monobenzoate); phenyl salicylates (e.g. phenyl salicylate, 4-t-butylphenyl salicylate); the others low molecular weight UV absorbers (e.g. [2,2'-thiobis(4-t-octylphenolate)]-n-butylamine nickel(II), 2-ethylhexyl diphenylmethylenecyan acetate); polymeric UV absorbers (e.g. 2-hydroxy-4-(3-methacryloxy-2-hydroxypropoxy)benzophenone, 2,2'-dihydroxy-4-(3-methacryloxypropoxy)benzophenone, 2,6-di-t-butyl-4-vinylphenol, 2-hydroxy-4-(vinylbenzyloxy) benzophenone, compounds described in UK Patent 898,065, US Patents 3,159,646, 3,141,903, 3,186,968, 2,883,361, 3,162,676, 3,173,893, 3,049,503, 3,107,199, 3,072,585 and Japanese Kokai Publication 56-125414.

In the present invention, the effects of inhibiting polymerization reactions are preferably defined by two parameters, i.e. intrinsic inhibition index and with-time inhibition index. The inhibition index is calculated from the following equation;

$$\text{Inhibition index} = (A\text{-}B)/A \times 100$$

[wherein A = a dot diameter (micron) when the matte layer does not contain the polymerization inhibiting material, B = a dot diameter (micron) when the matte layer contains the polymerization inhibiting material.]

The samples plates are prepared by covering a resin plate composed of a substrate and a photosensitive resin layer thereon with a matte layer and leaving it for a certain day at 20 °C, followed by exposing to light through a negative film having 65 1pi(line per inch) half tone and 10 % circular dots and then developing. A is determined when the matte layer does not contain the polymerization inhibiting material and B is determined when the matte layer contains it, using a reflection-type microscope. In the present invention, the intrinsic inhibition index is defined as determining after one day leaving and the with-time inhibition index is defied as determining after 7 days leaving. According to the present invention, it is preferred that the intrinsic inhibition index is not less than 3, more preferably not less than 5, most preferably not less than 8. The with-time inhibition index is preferably not less than 3, more preferably not less than 5, most preferably not less than 8. Although the polymerization inhibition is depending upon other conditions, such as compositions and properties of the photosensitive resin layer or the resin matte layer, it is more preferred in view of the inhibition index that the polymerization inhibiting materials are sodium dialkyldithiocarbamate, especially sodium diethyldithiocarbamate, sodium dipropyldithiocarbamate and sodium dibutyldithiocarbamate as polymerization inhibitors; cupferrone as polymerization stopper; β-naphthol, t-butylphenol, pentaerythrityl-tetrakis[3-(3,5-di-t-butyl-4-hydroxyphenyl) propionate], 2,2-thiodiethylenebis-[3-(3,5-di-t-butyl-4-hydroxyphenyl) propionate] as antioxidants.

The polymerization inhibiting material may be present in the matte layer in an amount of 0.1 to 70 % by weight, preferably 0.3 to 55 % by weight, based on the total amount of the matte layer. Amounts of less than 0.1 % by weight have poor polymerization inhibition effects and increase dot gain. Amounts of more than 70 % by weight provide poor relief because of poor hilight dots remaining properties, and reduce physical properties of dots.

The photosensitive resin layer of the present invention can be anyone known to the art and be water developable or organic solvent developable. Typical examples of the water developable photosensitive resin compositions are described in EP-A 164,270 and US Patents 4,952,481 and 4,957,850. Typical examples of the organic solvent developable compositions are described in US Patents 4,323,637, 4,234,676 and 4,264,705 and Japanese Kokai Publication 52-6430. A thickness of the photosensitive resin layer is generally within the range of 0.2 to 10.0 mm. It is preferred for flexographic printing that the photosensitive resin layer, when cured, has a Shore A hardness of 30 to 80 ° and an impact resilience of 20 % or more.

The substrate for the resin plate can be anyone known to the art, for example metal plates, such as iron, stainless, copper, zinc and aluminum; rubber sheets, such as natural rubber or synthetic rubber; plastic sheets or films, such as celluloid, cellulose acetate, polyethylene, polypropylene, polyvinyl chloride, polymethyl methacrylate, polystyrene, polycarbonate, polyethylene tetephthalate and polyamide. The substrate generally has a thickness of 0.025 to 0.5 mm, preferably 0.05 to 0.4 and also is covered with a halation-preventing layer and an adhesive layer.

The photosensitive resin plate of the present invention can be prepared by known methods, for example by forming the photosensitive resin layer on the substrate and then forming a resin matte layer thereon. The plate is then exposed to active light beams through a negative film and then developed to form a relief. Typical examples of the active light beam sources are low-pressure mercury lamps, high-pressure mercury lamps, ultrahigh-pressure mercury lamps, ultraviolet fluorescent lamps, carbon arc lamps, xenon lamps and the sun light. The developer can be anyone known to the art, including organic solvents, such as alcohols, acetone, benzene, toluene, chloroethane and chloroethylene; water or alkaline aqueous solvents containing, for example, sodium hydroxide, sodium carbonate, sodium phosphate, sodium tripolyphosphate, sodium borate and sodium silicate.

The photosensitive resin plate of the present invention is very suitable for flexographic printing and significantly reduces dot gain.

## EXAMPLES

The present invention is illustrated by the following Examples which, however, are not to be construed as limiting the present invention to their details.

## Example 1

A resin matte composition was prepared by mixing 15 parts by weight of hydroxymethylcellulose and 95 parts by weight of distilled water and then dissolving 4 parts by weight of silica having an average particle size of 15 micrometer therein, followed by adding Cupferron (a polymerization inhibitor available from Wako Pure Chemical Industries, Ltd.).

Separately, a photosensitive resin composition, which, when cured, had a Shore A hardness of 70 ° and an impact resilience of 32 %, was prepared by mixing 66.5 parts by weight of a copolymer (composed of 80 mol % of butadiene, 6.5 mol % of methacrylic acid, one mol % of divinylbenzene and 12.5 mol% of methyl metahacrylate), 8 parts by weight of N,N-dimethylaminopropyl methacrylate, 6 parts by weight of phenoxyethoxy ethanol, 12 parts by weight of lauryl methacrylate, 5 parts by weight of trimethylolpropane triacrylate, 2 parts by weight of 2,2-dimethoxy-2-phenyl acetophenone and 0.5 parts by weight of 2,6-di-t-butyl-p-cresol, using a double roll at 60 °C, followed by further mixing by a pressured double screw kneader. The composition was extruded by a double screw extruder onto an iron plate to form a photosensitive resin layer having a thickness of about 0.4 mm and a mirror smooth surface.

On the photosensitive resin composition, the previously obtained resin matte composition was coated in a thickness of 3 micrometer when dried, and dried at 70 °C for 2 minutes to obtain a photosensitive resin composition.

After the resulting resin plate was left at 20 °C for one day, a negative film was closely placed thereon in vacuum and then exposed to a 3 KW ultrahigh pressure mercury lamp for 40 minutes. It was then developed with water at 40 °C for 2 minutes, using a brush, and dried at 110 °C for 2 minutes in a drying chamber equipped with a 2 KW high pressure mercury lamp. It had an intrinsic inhibition index of 10.

The dots diameters which were actually used are shown in Table 1.

Table 1

| Hilight dots 65 lpi | 5% | 10% | 80% | 90% |
|---|---|---|---|---|
| Negative diameter | 98 | 139 | 196 | 120 |
| Diameter without polymerization inhibiting material | 95 | 135 | 197 | 120 |
| Diameter with polymerization inhibiting material | 89 | 122 | 202 | 120 |

All numbers show micron.

If the negative dot diameter is less than 50 %, the numbers show dot diameters in the cured portion, and if it is more than 50 %, the numbers show dot diameter in the uncured portion.

After the resin plate was left at 20 °C for 7 days, the inhibition index was also determined to be 7.

## Example 2

The operation of Example 1 was repeated with the exception that the matte resin composition was prepared by dispersing 4 parts by weight of silica having an average particle size of 15 micrometer in a solution of 15 parts by weight of hydroxy cellulose and 95 parts by weight of distilled water and then adding 19 parts by weight of sodium dibutyldithiocarbamate (a polymerization stopper) thereto.

The resulting resin plate had an intrinsic inhibition index of 16 and a with-time inhibition index of 12.

The resulting printing plate was printed using a flexographic printing machine on craft paper at 200 m/sec. No changes on the relief surface were observed after four hours and printed paper sheets had food and faithful images. The results of the printing is shown in Table 2.

Comparative Example 1

The operation of Example 2 was repeated with the exception that sodium dibutyldithiocarbamate was not employed and the results of the printing is shown in Table 2.

Comparative Example 2

The operation of Example 2 was repeated with the exception that 2 parts by weight of sodium dibutyldithiocarbamate was employed instead of 19 parts by weight of it and the results of the printing is shown in Table 2.

The resin plate had an intrinsic inhibition index of 2.

As is apparent from Comparative Example 2, if the intrinsic inhibition index is low, the dot diameter of the printing plate was larger and the printed images had distinct dot gain.

Example 3

The operation of Example 1 was repeated with the exception that the matte resin composition was prepared by dispersing 4 parts by weight of silica having an average particle size of 15 micrometer in a solution of 15 parts by weight of hydroxy cellulose and 95 parts by weight of distilled water and then adding 3 parts by weight of an antioxidant available from Ciba Geigy AG as IRGANOX 1010 thereto.

The resulting resin plate had an intrinsic inhibition index of 6 and a with-time inhibition index of 6.

Example 4

The operation of Example 1 was repeated with the exception that the matte resin composition was prepared by dispersing 4 parts by weight of silica having an average particle size of 15 micrometer in a solution of 15 parts by weight of hydroxy cellulose and 95 parts by weight of distilled water and then adding 2 parts by weight of a UV absorber available from Ciba Geigy AG as IRGANOX 1130 thereto.

The resulting resin plate had an intrinsic inhibition index of 3 and a with-time inhibition index of 2.

Example 5

A photosensitive resin sheet, which showed a Shore A hardness of 55 ° and an impact resilience of 62 % when cured, was prepared from crystalline 1,2-polybutadiene, dioctyltetrahydrophthalate, neopentylglycol dimethacrylate and a polymerization initiator and formed into a 5 mm thick photosensitive resin sheet. A polyester sheet was adhered onto the photosensitive resin sheet as backing.

Separately, a protective polyester sheet having a surface roughness of 3.0 micron and a thickness of 100 micron was coated with a solvent type silane coupling agent (available from Toray Silicone Co., Ltd. as Toray Silicone SRX-244 including a catalyst SRX-242 AC), using a doctor blade in a thickness of 0.5 micron, and was allowed to stand for one day at room temperature. On the silicone, a 5 wt % isopropyl alcohol / toluene solution of 100 parts by weight of mediam type ethyl cellulose containing an ethoxy of 45 % (available from Dow Company) and 16 parts by weight of sodium dibutyl dithiocarbamate was coated in a 1.5 micron thickness and dried.

Next, the photosensitive resin sheet having a backing layer was heated at 80 °C for 2 minutes in a hot air drier. Upon taking it out of the drier, the protective polyester film was melt-adhered on the photosensitive layer, facing the silicone surface with the photosensitive layer, and then placed on a cool surface for 10 minutes to obtain a photosensitive resin plate.

After the resulting resin plate was left at 20 °C for one day; a negative film was closely placed thereon in vacuum and then exposed to a chemical lamp for 10 minutes. It was then developed with a mixture of 25 wt % of isopropyl alcohol and 75 wt % of 1,1,1-trichloroethane for one minute, using a brush, and dried at 50 °C for 20 minutes in a drying chamber equipped with a 2 KW high pressure mercury lamp. It had an intrinsic inhibition index of 10 and a with-time inhibition index of 8.

EP 0 465 034 B1

Table 2

|  | 10 % Hilight plate dot diameter (μ) | 10 % Hilight printed paper dot diameter (μ) |
| --- | --- | --- |
| Example 2 | 117 | 182 |
| Example 5 | 128 | 172 |
| Comparative Ex. 1 | 139 | 235 |
| Comparative Ex. 2 | 138 | 221 |

## Claims

1. A photosensitive resin plate for flexographic printing comprising a substrate, a photosensitive resin layer formed on said substrate and a resin matte layer formed on said photosensitive resin layer, characterized in that said resin matte layer contains a polymerization inhibiting material.

2. The photosensitive resin plate according to Claim 1 wherein said resin matte layer is prepared from a resin matte composition comprising

   (a) a binder resin, and
   (b) a polymerization inhibiting material.

3. The photosensitive resin plate according to Claim 2 wherein said polymerization inhibiting material is present in the resin matte composition in an amount of 0.1 to 50 % by weight based on the total composition weight.

4. The photosensitive resin plate according to Claim 2 wherein said binder resin (a) is selected from the group consisting of cellulose, polyvinyl alcohol, polyamide and polyacrylamide.

5. The photosensitive resin plate according to Claim 1 wherein said polymerization inhibiting material includes polymerization inhibitors, polymerization stoppers, chain transferring agents, polymerization regulators, antioxidants or ultraviolet absorbers.

6. The photosensitive resin plate according to Claim 5 wherein said polymerization inhibiting materials are selected from the group consisting of sodium dialkyldithiocarbamate, β-naphthol, cupferrone, t-butylphenol, pentaerythrityltetrakis[3-(3,5-di-t-butyl-4-hydroxyphenyl) propionate] and 2,2-thiodiethylenebis-[3-(3,5-di-t-butyl-4-hydroxyphenyl) propionate].

7. The photosensitive resin plate according to Claim 1 wherein said resin matte layer has an intrinsic inhibition index of 3 or more and a with-time inhibition index of 3 or more, calculated from the following equation;

$$\text{Inhibition index} = (A-B)/A \times 100$$

   [wherein A = a dot diameter (micron) when the matte layer does not contain the polymerization inhibiting material, B = a dot diameter (micron) when the matte layer contains the polymerization inhibiting material.]
   when the intrinsic inhibition index is defined as determining after one day leaving a photosensitive resin plate and the with-time inhibition index is defied as determining after 7 days leaving a photosensitive resin plate.

8. The photosensitive resin plate according to Claim 1 wherein said photosensitive resin layer, when cured, has a Shore A hardness of 30 to 80 ° and an impact resilience of 20 % or more.

## Patentansprüche

1. Lichtempfindliche Harzplatte für den Flexodruck, umfassend ein Substrat, eine lichtempfindliche Harzschicht, gebildet auf dem Substrat, und eine matte Harzschicht, gebildet auf der lichtempfindlichen Harzschicht,
   dadurch **gekennzeichnet**, daß
   die matte Harzschicht ein Polymerisationsinhibitionsmaterial enthält.

2. Lichtempfindliche Harzplatte nach Anspruch 1, worin die matte Harzschicht aus einer matten Harzzusammensetzung hergestellt ist, umfassend

(a) ein Bindemittelharz und
(b) ein Polymerisationsinhibitionsmaterial.

3. Lichtempfindliche Harzplatte nach Anspruch 2, worin das Polymerisationsinhibitionsmaterial in der matten Harzzusammensetzung in einer Menge von 0,1 bis 50 Gew.-% vorhanden ist, bezogen auf das Gesamtgewicht der Zusammensetzung.

4. Lichtempfindliche Harzplatte nach Anspruch 2, worin das Bindemittelharz (a) ausgewählt ist aus der Gruppe, bestehend aus Cellulose, Polyvinylalkohol, Polyamid und Polyacrylamid.

5. Lichtempfindliche Harzplatte nach Anspruch 1, worin das Polymerisationsinhibitionsmaterial Polymerisationsinhibitoren, Polymerisationsstopper, Kettenübertragungsmittel, Polymerisationsregulatoren, Antioxidantien oder Ultraviolettabsorber enthält.

6. Lichtempfindliche Harzplatte nach Anspruch 5, worin die Polymerisationsinhibitionsmaterialien ausgewählt sind aus der Gruppe, bestehend aus Natriumdialkyldidthiocarbamat, β-Naphthol, Kupferron, t-Butylphenol, Pentaerythrityl-tetrakis[3-(3,5-di-t-butyl-4-hydroxyphenyl)propionat] und 2,2-Thiodiethylenbis-[3-(3,5-di-t-butyl-4-hydroxyphenyl)propionat].

7. Lichtempfindliche Harzplatte nach Anspruch 1, worin die matte Harzschicht einen Intrisik-Inhibitionsindex von 3 oder mehr und einen zeitabhängigen Inhibitionsindex von 3 oder mehr hat, berechnet aus der folgenden Gleichung:

$$\text{Inhibitionsindex} = (A-B)/A \times 100$$

[worin A = ein Punktdurchmesser (μm), wenn die matte Schicht das polymerisationsinhibitionsmaterial nicht enthält, B = ein Punktdurchmesser (μm), wenn die matte Schicht das Polymerisationsinhibitionsmaterial enthält], wenn der Intrinsik-Inhibitionsindex definiert wird als Bestimmung, nachdem eine lichtempfindliche Harzplatte einen Tag stehengelassen wird, und der zeitabhängige Inhibiotionsindex definiert wird als Bestimmung, wenn eine lichtempfindliche Harzplatte 7 Tage lang stehen gelassen wird.

8. Lichtempfindliche Harzplatte nach Anspruch 1, worin die lichtempfindliche Harzschicht nach dem Härten eine Shore A-Härte von 30 bis 80° und eine Schlagzähigkeit von 20 % oder mehr hat.

**Revendications**

1. Plaque en résine photosensible pour impression par flexographie, comprenant un support, une couche de résine photosensible formée sur ledit support et une couche de mat de résine formée sur ladite couche de résine photosensible, caractérisée en ce que ladite couche de mat de résine contient un matériau inhibiteur de polymérisation.

2. Plaque en résine photosensible selon la revendication 1, dans laquelle ladite couche de mat de résine est préparée à partir d'une composition de mat de résine comprenant:

(a) une résine de liant, et
(b) un matériau inhibiteur de polymérisation.

3. Plaque en résine photosensible selon la revendication 2, dans laquelle ledit matériau inhibiteur de polymérisation est présent dans la composition de mat de résine en quantité de 0,1 à 50% en poids, calculés sur le poids total de la composition.

4. Plaque en résine photosensible selon la revendication 2, dans laquelle ladite résine de liant (a) est choisie dans le groupe constitué de cellulose, alcool polyvinylique, polyamide et polyacrylamide.

5. Plaque en résine photosensible selon la revendication 1, dans laquelle ledit matériau inhibiteur de polymérisation inclut des inhibiteurs de polymérisation, des bloqueurs de polymérisation, des agents de transfert de chaîne, des régulateurs de polymérisation, des antioxydants et des absorbeurs d'ultraviolets.

**6.** Plaque en résine photosensible selon la revendication 5, dans laquelle lesdits matériaux inhibiteurs de polymérisation sont choisis dans le groupe constitué de dialkyldithiocarbamate de sodium, β-naphtol, cupferron, t-butylphénol, pentaérithrityl-tétrakis[3-(3,5-di-t-butyl-4-hydroxyphényl)propionate] et 2,2-thio-diéthylènebis-[3-(3,5-di-t-butyl-4-hydroxyphényl)propionate].

**7.** Plaque en résine photosensible selon la revendication 1, dans laquelle ladite couche de mat de résine présente un indice d'inhibition intrinsèque de 3 ou davantage et un indice d'inhibition dans le temps de 3 ou davantage, calculé à partir de l'équation suivante:

$$\text{Indice d'inhibition} = (A-B)/A \times 100$$

[dans laquelle A = diamètre d'un point (micromètres) lorsque la couche de mat de résine ne contient pas le matériau inhibiteur de polymérisation, B = diamètre d'un point (micromètres) lorsque la couche de mat de résine contient le matériau inhibiteur de polymérisation],
l'indice d'inhibition intrinsèque étant défini comme celui déterminé sur une plaque en résine photosensible après un jour, et l'indice d'inhibition dans le temps étant défini comme celui déterminé sur une plaque en résine photosensible après 7 jours.

**8.** Plaque en résine photosensible selon la revendication 1, dans laquelle ladite couche de résine photosensible présente, lorsqu'elle est durcie, une dureté Shore de 30 à 80° et une élasticité au choc de 20% ou davantage.